# EUROPEAN PATENT APPLICATION

(11) **EP 1 746 665 A2**
(43) Date of publication of application: **24.01.2007**
(21) Application number: 06014473.0
(22) Date of filing: 12.07.2006
(51) Int. Cl.: H01L 33/00, H01S 5/183

(54) **Semiconductor light emitting device and method of manufacturing the same**

(30) Priority: 22.07.2005 US 187469
(71) Applicant: Avago Technologies ECBU IP (Singapore) Pte. Ltd., Singapore 768923 (SG)
(72) Inventor: Robbins, Virginia M., Loveland CO 80537-0599 (US); Lester, Steven D., Loveland CO 80537-0599 (US)
(74) Representative: Schoppe, Fritz

(57) **Abstract**

A light emitting device (200) is manufactured by forming a light emitting structure (250) upon a buffer layer (225) formed on a substrate (220). The light emitting structure is then separated from the buffer layer and the substrate. A light-directing element (410) such as a mirror or a lens is then attached to the light emitting structure using a bonding agent (405).

## Description

### DESCRIPTION OF THE RELATED ART

It is desirable to fabricate devices in GaN material systems that include both light emitting layers and passive optical elements such as mirrors or lenses. An example would be a GaN vertical cavity surface emitting laser (VCSEL) with both a top and a bottom distributed Bragg reflector (DBR) mirror. The GaN material system presents challenges to fabricating such a device using epitaxial growth.

For example, attention is drawn to the paper titled "An optically pumped GaN-AlGaN vertical cavity surface emitting laser" by Joan M. Redwing, David A. S. Loeber, Neal G. Anderson, Michael A. Tischler and Jeffrey S. Flynn, which describes a VCSEL structure incorporating reflector stacks. The VCSEL structure is grown on a sapphire substrate by metalorganic vapor phase epitaxy (MOVPE).

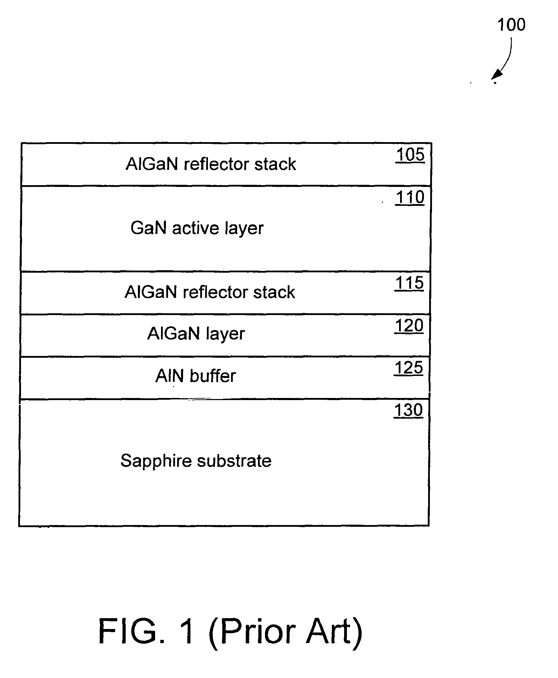

This prior-art VCSEL includes an active layer sandwiched between two reflector stacks as illustrated in FIG. 1 of the present disclosure. Active layer 110 is a 10µm GaN layer sandwiched between Bragg reflector stacks 105 and 115, each of which is a 30-period Al_{0.4}Ga_{0.60}N / Al_{0.12}Ga_{0.88}N(397Å/372Å) multilayer stack. Several shortcomings related to optical and mechanical characteristics have been disclosed in the referred paper. Such shortcomings include the presence of "a network of cracks" and reflectivity parameters that are sub-optimal for VCSEL performance.

In addition, if the light is extracted through the substrate the semiconductor light emitting device is further handicapped by optical signal losses. For example, the lossy characteristic of the semiconductor material used in the buffer layer formed adjacent to the substrate leads to optical signal loss and signal degradation. The substrate further introduces optical signal loss. It is therefore desirable to eliminate certain elements, such as the buffer layer and the substrate, which are present in existing light emitting devices.

### SUMMARY

A light emitting device is manufactured by forming a light emitting structure upon a buffer layer formed on a substrate. The light emitting structure is then separated from the buffer layer and the substrate. A light-directing element such as a mirror or a lens is then attached to the light emitting structure using a bonding agent.

### BRIEF DESCRIPTION OF THE DRAWINGS

Many aspects of the invention can be better understood with reference to the following drawings. The components in the drawings are not necessarily to scale. Instead, emphasis is placed upon clearly illustrating the principles of the invention. Moreover, in the drawings, like reference numerals designate corresponding parts throughout the several views.

FIG. 1 shows a prior art VCSEL containing a substrate upon which is grown an active region sandwiched between two reflector stacks.

FIG. 2 shows an exemplary embodiment of a light emitting device having a light emitting structure formed upon a substrate in accordance with the present invention.

FIG. 3 shows the light emitting structure of FIG. 2 separated from the substrate.

FIG. 4 shows a light-directing element attached to the light emitting structure of FIG. 3 using a bonding agent.

FIG. 5 shows a first exemplary embodiment of a light emitting device wherein the light-directing element is a mirror.

FIG. 6 shows a second exemplary embodiment of a light emitting device wherein the light-directing element is a lens.

FIG. 7 shows a flow chart of an exemplary method of manufacturing a light emitting device in accordance with the present invention.

### DETAILED DESCRIPTION

The various embodiments generally relate to a light emitting device having a light emitting structure to which is attached a light-directing element. In one exemplary embodiment, the light emitting structure is a light emitting source manufactured using a metalorganic chemical vapor phase epitaxy (MOVPE) process. The attached light-directing element is manufactured using a process other than MOVPE. The MOVPE process allows the light emitting structure to be optimized for optical and mechanical characteristics, while the other process allows the light-directing element to be optimized independent of the light emitting structure.

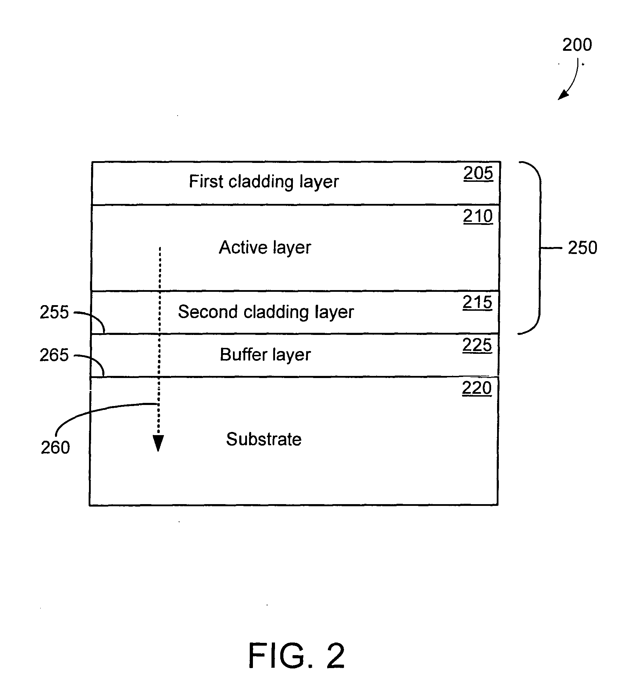

FIG. 2 shows an exemplary embodiment of a light emitting device 200, which, in this example, is a VCSEL, having a light emitting structure 250 that includes an active layer 210 composed of a GaN-based compound. In one exemplary embodiment, the GaN-based compound is defined by InₓAl_{y}Ga_{1-x-y}N (1≥x≥0; 1≥y≥0; 1≥x+y≥0). The active layer 210 is sandwiched between a first cladding layer 205 and a second cladding layer 215. The two cladding layers, which are sometimes referred to in alternative terms such as blocking layers and reflection layers, operate to confine light in the active layer 210 to generate laser light as is known in the art. Buffer layer 225 is formed adjacent to substrate 220.

While FIG. 2 shows light emitting structure 250 formed of active layer 210 sandwiched between first cladding layer 205 and second cladding layer 215, in alternative exemplary embodiments, light emitting structure 250 includes additional layers. Some examples of additional layers are: a current conduction layer and a contact layer. One or more of these additional layers are formed between buffer layer 225 and second cladding layer 215. In these alternative exemplary embodiments, the additional layers are a part of light emitting structure 250.

Attention is drawn to optical signal path 260 in light emitting device 200. Among several layers, buffer layer 225 and substrate 220 introduce optical signal attenuation in optical signal path 260. Consequently, it is desirable to minimize this attenuation by eliminating buffer layer 225 as well as substrate 220. As an additional benefit, elimination of buffer layer 225 and substrate 220 also leads to the elimination of semiconductor junctions 255 and 265. Junctions 255 and 265 contribute to optical signal loss by introducing signal absorption and signal scattering.

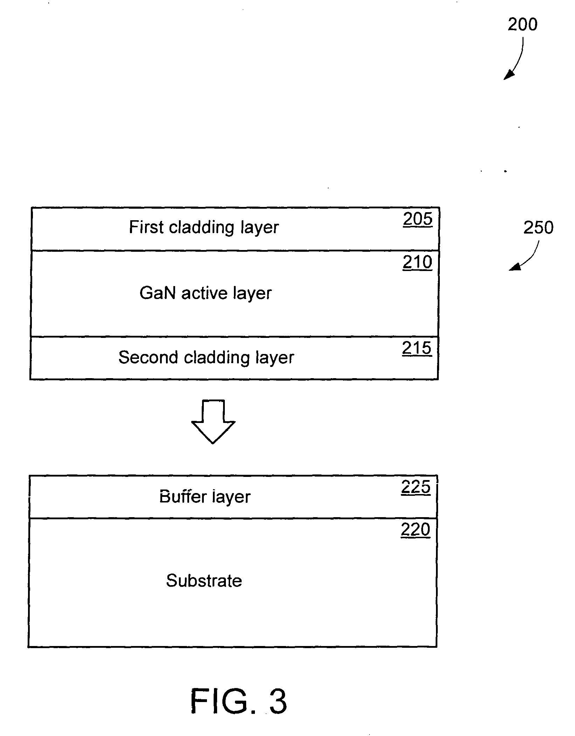

FIG. 3 shows light emitting structure 250 separated from buffer layer 225 thereby eliminating from light emitting structure 250, buffer layer 225, substrate 220 and junction 255 that was shown in FIG. 2. In one exemplary embodiment, light emitting structure 250 is separated from buffer layer 225 by using a laser liftoff process. In alternative embodiments, the separation is carried out using other techniques.

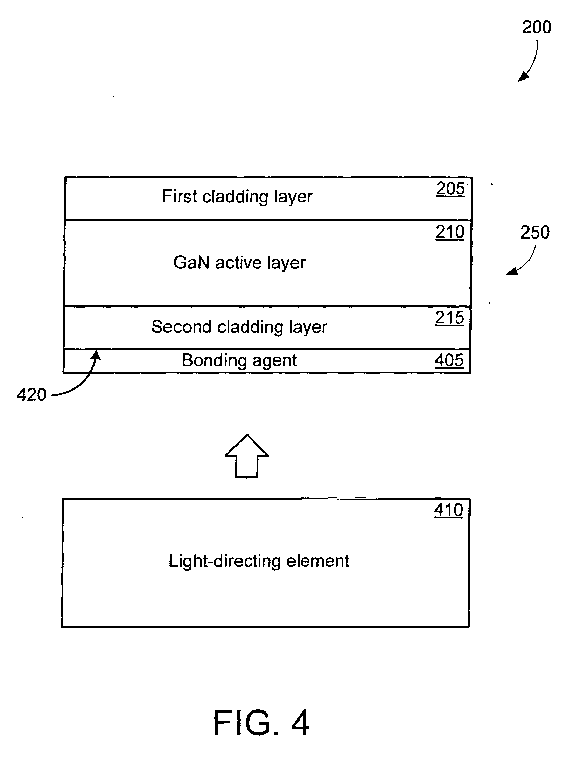

In FIG. 4 a bonding agent 405 is applied to a major surface of light emitting structure 250. In the exemplary embodiment shown in FIG. 4, a major surface 420 of second cladding layer 215 is shown as the major surface of light emitting structure 250 to which bonding agent 405 is applied. In an alternative embodiment, bonding agent 405 is applied to a major surface of a different layer, which is a part of light emitting structure 250. For example, bonding agent 405 is applied to a major surface of a current conduction layer (not shown) or a contact layer (not shown).

Various materials can be used in the composition of bonding agent 405. For example, an optical quality epoxy bond that is transparent and has low signal transmission loss for optical signals may be used. The epoxy bond provides adhesive qualities that allow an external element to be attached to the second cladding layer 215 in a semi-permanent or a permanent manner. As a second example, bonding agent 405 provides adhesion between two silicon-dioxide (SiO₂ surfaces.

Light-directing element 410 is an optical element used to direct one or more wavelengths of light in a desired direction. Some examples of light-directing element 410 are: a) a lens, b) a mirror, c) a grating, d) an optical filter, and e) an optical coupler. It will be understood that the term light-directing element is a general term used to describe several optical elements in addition to the few example elements provided above. Persons of ordinary skill in the art will recognize several other such elements.

Light-directing element 410 is produced as a unit of manufacture by using a manufacturing process that is advantageous to produce such a light directing structure. On the other hand, light emitting structure 250 is independently manufactured as a second unit using a manufacturing process that is more suitable for producing an optimal light emitting structure. The method of manufacturing light-directing element 410 and of light emitting structure 250 will be explained below in further detail.

The manufacture of light-directing element 410 depends on the nature of the light-directing element. For example, when light-directing element 410 is a semiconductor device an epitaxial growth process similar to the one used to manufacture light emitting structure 250 is used. In one exemplary embodiment, the two epitaxial growth processes used for individually manufacturing the two units are identical to one another. In another exemplary embodiment, the two epitaxial growth processes differ from one another in terms of manufacturing parameters such as growth temperature, rate of growth etc., though the semiconductor materials such as GaN, AlGaN, and AIN that are used in growing the two units are identical to one another. Here again, the two units are manufactured independent to one another.

When light-directing element 410 is made of a material such as glass, a manufacturing process that is applicable to glass rather than to semiconductor material is used. For example, when light-directing element 410 is a lens, the lens is manufactured from a glass blank that is cut, ground, and shaped suitably. In this example, light-directing element 410 is manufactured using a glass-related manufacturing process, while light emitting structure 250 is independently manufactured using an epitaxial growth process.

Light-directing element 410 is attached to second cladding layer 215 using bonding agent 405. Bonding agent 405 is typically selected based on optical properties related to minimizing optical signal loss. Bonding agent 405 is also selected based on physical characteristics such as adhesion and stress.

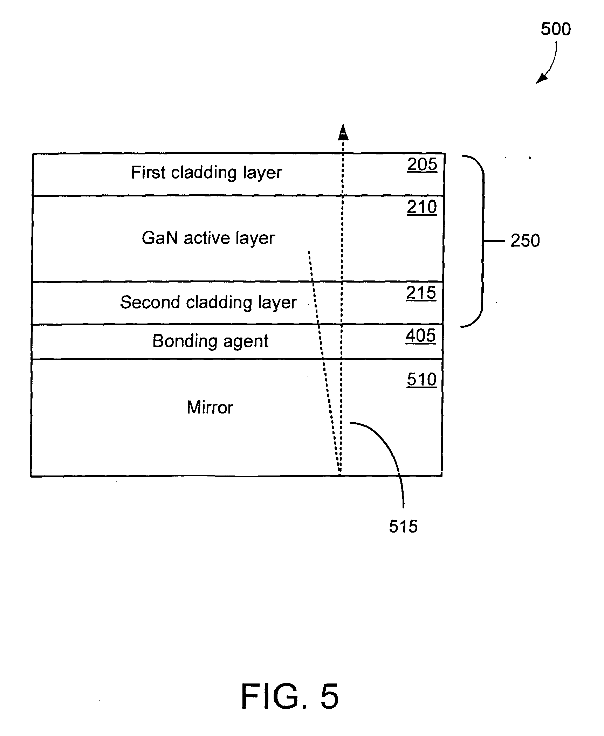

FIG. 5 shows an exemplary embodiment of a light emitting device 500 wherein the light-directing element is a mirror 510. Mirror 510 is manufactured as a first unit of manufacture independent to the manufacture of light emitting structure 250. In one exemplary embodiment, mirror 519 is manufactured by coating a material of a certain dielectric constant upon another material having a different dielectric constant. The two materials are individually selected based on certain desired properties and the manufacturing process is carried out in an optimal manner, thereby leading to improved characteristics of mirror 519. Such improved characteristics include higher reflectivity and better mechanical strength.

Mirror 510 is attached to light emitting structure 250 using bonding agent 405, which is selected to provide a desirable level of adhesion between the material of mirror 510 and, in this example, the material of second cladding layer 215.

Optical signal path 515 depicts the reflective action provided by mirror 510. The elimination of substrate 220 and junction 255 that were shown in FIG. 2 minimizes signal attenuation and signal deterioration in optical signal path 515.

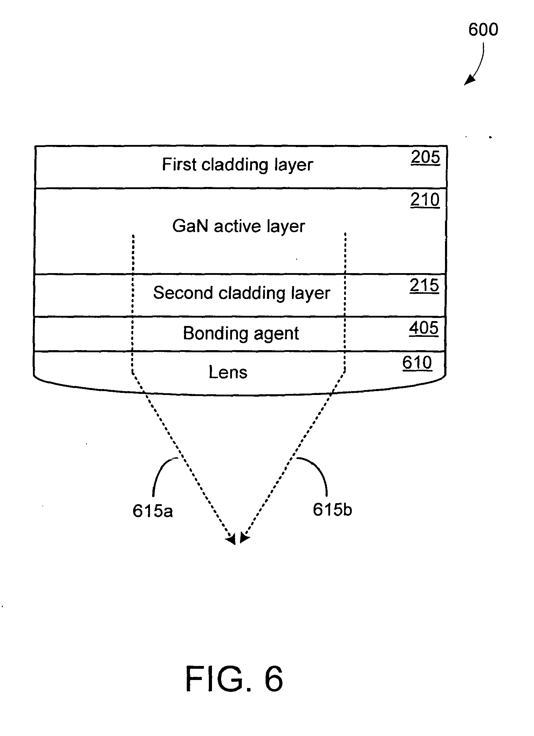

FIG. 6 shows an exemplary embodiment of a light emitting device 600 wherein the light-directing element is a lens 610. Lens 610 is manufactured as a first unit of manufacture independent to the manufacture of light emitting structure 250. In one exemplary embodiment, lens 610 is manufactured from a glass blank that is suitably cut, shaped, and processed. Lens 610 is attached to light emitting structure 250 using bonding agent 405, which is selected to provide a desirable level of adhesion between glass and the semiconductor material of second cladding layer 215.

Optical signal paths 615a and 615b depict the focusing action provided by lens 610. The elimination of buffer 225, substrate 220 and junctions 255 and 265 that were shown in FIG. 2 minimizes signal attenuation and signal deterioration in optical signal paths 615a and 615b.

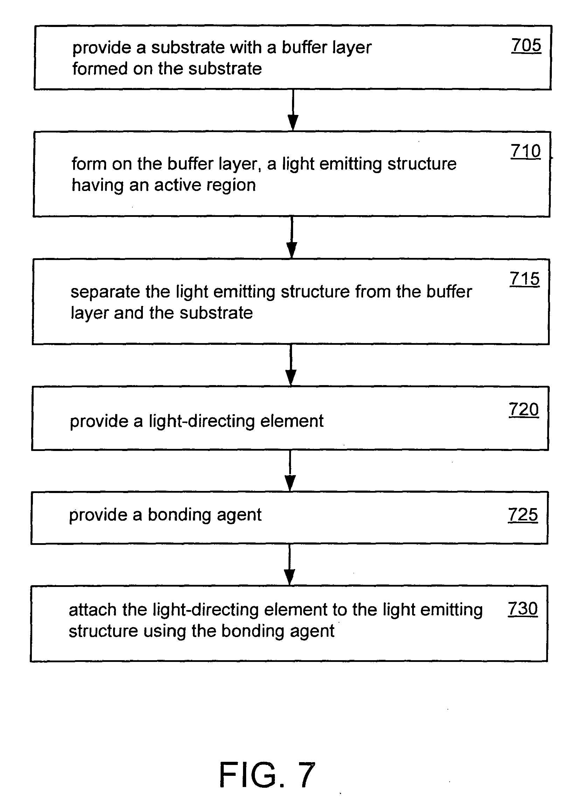

FIG. 7 shows a flow chart of an exemplary method of manufacturing a light emitting device in accordance with the present invention. In block 705 a substrate with a buffer layer formed on the substrate is provided. In one exemplary embodiment, the substrate is a sapphire substrate and the light emitting device is a VCSEL. In other embodiments, substrates of other materials are provided.

In block 710, a light emitting structure is formed on the buffer layer. In one embodiment, the light emitting structure is formed using a metalorganic chemical vapor phase epitaxy (MOVPE) process. In other embodiments, the light emitting structure is formed using other processes such as chemical etching and laser etching. The light emitting structure includes an active region, which persons of ordinary skill in the art will recognize is a part of a laser light generation structure.

In block 715, the light emitting structure is separated from the buffer layer and the substrate using a suitable process such as laser liftoff. In block 720, a light-directing element is provided. Some examples of light-directing elements include a lens, a mirror, a grating, and an optical filter.

In block 725, a bonding agent is provided. The bonding agent is selected to provide optimal mechanical and optical properties to the light emitting device. One example of a bonding agent is an optical epoxy bond. A second example is an optical gel that provides temporary adhesion. In block 730, the light-directing element is attached to the light emitting structure using the bonding agent.

The above-described embodiments are merely set forth for a clear understanding of the principles of the disclosure. Many variations and modifications may be made without departing substantially from the disclosure. All such modifications and variations are included herein within the scope of this disclosure.

## Claims

1. A light emitting device (200) comprising:
a light emitting structure (250) comprising an active layer (210) formed of InₓAl_{y}Ga_{1-x-y}N;
a bonding agent (405) applied to a major surface (420) of the light emitting structure; and
a light-directing element (410) attached by the bonding agent to the major surface of the light emitting structure.

2. The light emitting device of claim 1, wherein:
the light emitting structure is a first unit of manufacture; and
the light-directing element is a second unit of manufacture independent of the first unit of manufacture.

3. The light emitting device of claim 2, wherein:
the light emitting structure is manufactured using metalorganic chemical vapor phase epitaxy (MOVPE) process; and
the light-directing element is manufactured using a process other than MOVPE.

4. The light emitting device of claim 3, wherein the major surface of the light emitting structure is a major surface of a cladding layer (215) that is located adjacent to the active layer of the light emitting structure.

5. The light emitting device of claim 3, wherein the major surface of the light emitting structure is a major surface of one of a current conduction layer and a contact layer.

6. A method for a light emitting device (200), the method comprising:
providing a substrate (220) with a buffer layer (225) formed on the substrate;
forming on the buffer layer, a light emitting structure (250) comprising an active region (210);
separating the light emitting structure from the buffer layer and the substrate;
providing a light-directing element (410);
providing a bonding agent (405); and
attaching the light-directing element to the light emitting structure using the bonding agent.

7. The method of claim 6, wherein the active region comprises InₓAl_{y}Ga_{1-x-y}N.

8. The method of claim 7, wherein the light-directing element is one of a) a lens, b) a mirror, c) a grating, and d) an optical filter element.

9. The method of claim 7, wherein attaching the light-directing element to the light emitting structure comprises attaching the light-directing element to a cladding layer (215) of the light emitting structure.

10. The method of claim 7, wherein attaching the light-directing element to the light emitting structure comprises attaching the light-directing element to one of a current conduction layer and a contact layer of the light emitting structure.
